# EUROPÄISCHE PATENTSCHRIFT

(11) **EP 0 517 999 B1**
(45) Veröffentlichungstag und Bekanntmachung des Hinweises auf die Patenterteilung: **02.08.1995**
(21) Anmeldenummer: 92101500.4
(22) Anmeldetag: 30.01.1992
(51) Int. Cl.: H01J 37/32

(54) **Vorrichtung für reaktive Ionenätz- und plasmaunterstützte CVD-Verfahren**
Apparatus for reactive ion beam etching and plasma-assisted CVD processing
Dispositif pour l'érosion réactive à faisceau ionique et le dépôt chimique par vapeur assisté par plasma

(30) Priorität: 12.06.1991 DE 4119362
(43) Veröffentlichungstag der Anmeldung: 16.12.1992
(73) Patentinhaber: LEYBOLD AKTIENGESELLSCHAFT, D-63450 Hanau (DE)
(72) Erfinder: Gegenwart, Rainer, Dr., W-6074 Rödermark (DE); Ritter, Jochen, Dipl.-Ing., W-6312 Laubach 1 (DE)

(56) Entgegenhaltungen:
- EP-A- 0 279 895
- EP-A- 0 286 132
- EP-A- 0 407 169
- US-A- 4 940 015

## Beschreibung

Die Erfindung betrifft eine Vorrichtung für Ionenätz- und plasmaunterstützte CVD-Verfahren entsprechend dem Oberbegriff des Patentanspruchs 1. Eine solche Vorrichtung ist aus EP-A- 0 407 169 bekannt.

Die PE-CVD-Technik ist eine plasmachemische Methode zur Oberflächenbeschichtung.

Im Gegensatz zu den konventionellen Vakuumbeschichtungsverfahren, Sputtern und Aufdampfen, wird bei der PE-CVD-Technik (Plasma-Enhanced Chemical Vapor Deposition) das Beschichtungsmaterial gasförmig zugeführt.

Die in die Vakuumkammer eingelassenen Gasmoleküle werden in einer Glimmentladung durch Elektronenstoß ionisiert, dissoziiert und angeregt. Die angeregten Moleküle und Ionen reagieren an den Substratoberflächen und lagern sich auf ihnen ab. Dabei bilden sie auf den Substraten eine geschlossene Schicht.

Auf dem Gebiet der CVD- und Ätztechnik sind Vorrichtungen allgemein bekannt, die mit RF-Plasmaanregung in Parallelplattenreaktoren arbeiten, wobei jedoch die Energie der auf die Substrate treffenden Teilchen nicht unabhängig von der Plasmaanregung eingestellt werden kann.

Im Speziellen ist eine Vorrichtung bekannt (DE P 40 37 091.7), die zur Erzeugung von Plasmen Mikrowellen einsetzt, die in Verbindung mit Magnetfeldern eine Elektronen-Zyklotron-Resonanz und damit eine erhöhte Ionisierung von Atomen und Molekülen bewirken.

Weiterhin ist eine Teilchenquelle für eine reaktive Ionenstrahlätz- oder Plasmadepositionsanlage bekannt (DE 38 03 355), die einen Behälter besitzt, der ein für die Plasmaanregung vorgesehenes Gas oder Gasgemisch umschließt, eine Zuführung aufweist für elektromagnetische Wellen, vorzugsweise Mikrowellen (»W), die dem Gas oder Gasgemisch Mikrowellenenergie zuführt, einen ersten Magnetfelderzeuger enthält, der so gerichtet ist, daß ein Magnetfeld in das Innere des Behälters hineinragt, sowie einen zweiten Magnetfelderzeuger enthält, der zentrisch zum ersten Magnetfelderzeuger angeordnet ist.

Die wesentlichen Nachteile der RF-Plasmaanregung in Parallelplattenreaktoren sind die starke Kopplung von Plasmaanregung und Abscheide- oder Ätzverhalten (Bias von RF-Leistung abhängig) am Substrat sowie die Begrenzung der Substratgröße durch die Gleichmäßigkeit der RF-Anregung und der Gasdynamik.

Für die obengenannte »W-Plasmaprozesse ist nachteilig, daß diese nicht in Durchlaufanlagen eingesetzt werden können und bei statischen Prozessen auf runde Substrate mit bis zu 200 mm Durchmesser beschränkt sind.

Der vorliegenden Erfindung liegt daher die Aufgabe zugrunde, die obengenannten Nachteile abzustellen sowie weiterhin die Anlagen- und Betriebskosten zu reduzieren, d. h. eine einfache Bauart der Quelle, geringe Kontamination der Kammerinnenwände zu erreichen und somit die Zeitabstände zwischen den Wartungsintervallen zu verlängern.

Diese Aufgabe wird gemäß den Merkmalen des Patentanspruchs 1 gelöst.

Die erfindungsgemäße Teilchenquelle wird mit Vorteil als kompakte Einheit an eine Vakuumkammer angeflanscht und ist problemlos und schnell von dieser zu trennen. Die Standzeit der Plasmaquelle wurde verlängert.

Durch Zünden eines Plasmas zwischen dem Koppel- und dem Schutzfenster wird nun die Ausbildung eines Bereiches mit für elektromagnetische Wellen variablem Brechungsindex ermöglicht und somit eine vorteilhafte Vergleichmäßigung der durch das Schutzfenster durchtretenden elektromagnetischen Welle bewirkt. Eine weitere Verbesserung sowie eine Variation der Verteilung der Mikrowellen in der Plasmakammer wird durch entlang des »W-Hohlleiters austauschbar angeordnete T-förmige Koppelglieder ermöglicht.

Die Kontamination in der Gesamtanlage wird ebenfalls erheblich verringert, und zwar durch den Einschluß der angeregten Teilchen in der Plasmakammer (Plasma-confinement) und durch eine Gitteranordnung im Bereich zwischen dem Plasma und dem zu beschichtenden Substrat. Dadurch können Instabilitäten während des Prozeßablaufs und das Abblättern unkontrolliert entstandener Schichten vermieden werden. Das Koppelfenster, das den Raum atmosphärischen Drucks in dem »W-Hohlleiter von dem Vakuumraum in der Plasmakammer trennt, gilt als besonders exponiertes Bauteil in bezug auf Kontamination; durch ein vor dem Koppelfenster angeordnetes, aufgeheiztes Schutzfenster weist nun das Koppelfenster mit Vorteil höhere Standzeiten sowie geringere Partikelerzeugung auf.

Weitere Ausführungsmöglichkeiten und Merkmale sind in den Unteransprüchen näher beschrieben und gekennzeichnet.

Die Erfindung läßt verschiedene Ausführungsmöglichkeiten zu; einige davon sind in den anhängenden Zeichnungen näher dargestellt, und zwar zeigen:
- Fig. 1: eine Teilchenquelle für Plasma-CVD- und Ätzprozesse in schematischer Darstellung, im wesentlichen bestehend aus einer Plasmakammer, einem Magnetsatz und Gaszuführungen,
- Fig.2: einen doppelten Magnetfeldring als Ausschnitt einer Anordnung ähnlich Fig. 1 in schematischer Darstellung,
- Fig. 3: den schematischen Verlauf eines Plasmaschlauchs in Form eines "Racetracks" entlang der Schnittlinie A-A in Fig. 2,
- Fig. 4a: einen Ausschnitt aus einer Koppelstelle zwischen einem Wellenleiter und der Plasmakammer mit einem T-förmigen Koppelglied und
- Fig. 4b: einen Ausschnitt aus einer Koppelstelle zwischen einem Wellenleiter und der Plasmakammer (wie 4a) mit zwei T-förmigen Koppelgliedern.

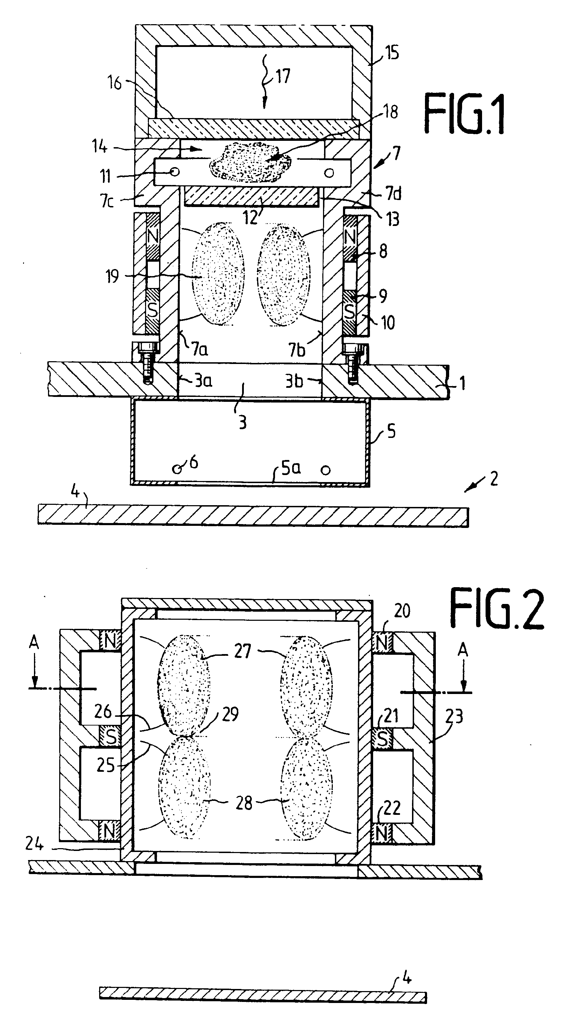

Wie Figur 1 zeigt, befindet sich in der Kammerwand 1 einer Vakuumkammer 2 eine rechteckige Öffnung 3. In der Kammer 2 ist unterhalb der Öffnung 3 ein zu beschichtendes Substrat 4 vorbeibewegbar, wobei zwischen Kammerwand 1 und Substrat 4 ein Gitter 5 (Plasma-confinement) mit Reaktivgaszuführung 6 vorgesehen ist. Außerhalb der Vakuumkammer 2 befindet sich eine Plasmakammer 7, die vakuumdicht an die Kammerwand 1 anschließt und wobei die inneren Wandflächen 7a, 7b der Plasmakammer 7 unmittelbar in Verlängerung der Begrenzungsflächen 3a, 3b der Öffnung 3 anschließen. Die Seitenwände 7c, 7d der Plasmakammer 7 weisen einen spiegelsymmetrischen Verlauf auf. In der einen Vertiefung, die der Kammerwand 1 am nächsten ist, sind auf der Außenseite der Wände 7c, 7d die Magnete 8, 9 angeordnet und mit einem Joch 10 miteinander verbunden. Eine zweite Einbuchtung befindet sich an der der Kammerwand 1 abgewandten Seite der Plasmakammer 7. In dieser Einbuchtung ist im Innenraum der Kammer 7 eine Gaszuführung 11 vorgesehen, wobei der Raum um diese Gaszuführung 11 durch ein Schutzfenster 12 aus Quarzglas vom übrigen Innenraum der Plasmakammer 7 abgegrenzt ist. Dieses Fenster 12 steht nicht in direktem Kontakt mit den Kammerwänden 7c, 7d, sondern ist durch einen Spalt 13 von diesen getrennt und somit thermisch nahezu entkoppelt.

Oberhalb der Gaszuführung 11 weist die Plasmakammer 7 eine Öffnung 14 auf, die in Form und Größe identisch ist der Öffnung 3 in der Kammerwand 1 und dieser gegenüberliegend angeordnet ist. An diese Öffnung 14 schließt sich ein rechteckförmiger Hohlleiter 15 an, wobei zwischen diesem und der Plasmakammer 7 ein Koppelfenster 16 aus Quarzglas vorgesehen ist, so daß der in dem Hohlleiter 15 befindliche Bereich atmosphärischen Drucks von den übrigen Bereichen innerhalb der Plasmakammer 7, in denen ein Vakuum von ca. 1 x 10⁻³ mbar herrscht, getrennt ist.

Aus einer nicht dargestellten Mikrowellenquelle werden Mikrowellen 17 in den Hohlleiter 15 eingespeist und durch das Fenster 16 in einen Zwischenplasmaraum zwischen den beiden Fenstern 16, 12 eingekoppelt. Bei Zufuhr von beispielsweise inertem, 0₂- oder N₂-Gas mittels der Gaszuführung 11 bildet sich zwischen den beiden Fenstern 16 und 12 ein Zwischenplasma 18 aus. Beim Durchgang der Mikrowellen 17 durch dieses Plasma 18 und das Schutzfenster 12 wird die Leistungsverteilung der Mikrowelle 17 wegen des variablen Brechungsindexes im Zwischenplasmaraum vergleichmäßigt. Die im Zwischenplasma 18 angeregten Spezies (Ionen, Elektronen) strömen aus diesem Zwischenplasmaraum durch einen Spalt 13 in den Plasmaraum zwischen dem Schutzfenster 12 und dem Substrat 4 und übertragen somit die Anregung auf das aus der Gaszuführung 6 austretende Reaktivgas. Es entsteht ein zweites Plasma 19, das durch die Anordnung der Magnetfeldlinien zwischen den Magneten 8, 9 zwei Bereiche größter Plasmakonzentration ausbildet.

Das Gitter 5 führt zu einem zusätzlichen Einschluß des Plasmas 19, so daß die angeregten Teilchen nur durch eine Öffnung 5a definierter Größe aus dem Plasmaraum auf das zu beschichtende Substrat 4 gelangen und somit eine mögliche Kontamination des Innenraumes der Kammer 2 auf ein Minimum reduziert wird.

Einen Ausschnitt einer Teilchenquelle - ähnlich der oben beschriebenen - zeigt Figur 2. Sie unterscheidet sich jedoch von der vorhergehenden durch je 3 Magnete 20, 21, 22, die über ein Joch 23 miteinander verbunden sind, so daß sich im Innenraum der Plasmakammer 24 die Magnetfeldlinien 25, 26 doppelt ausbilden. In diesem Magnetfeld wird ein Plasma 27, 28 gezündet, das seine größte Intensität jeweils in einem ovalen Bereich aufweist, der sich im Maximum der Magnetfeldlinien 25, 26 einstellt. Durch den doppelten Magnetfeldring 25, 26 bildet sich ein magnetischer Flansch 29 aus, in dem die Elektronendichte erhöht ist.

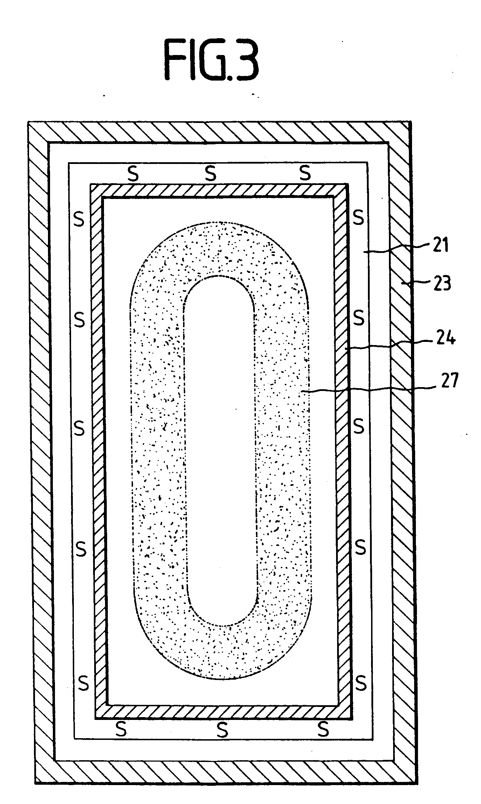

Bei einer rechteckigen Ausführung der Plasmakammer 24 (Figur 3) stellt sich ein in Form eines "Racetrack" ausgebildeter Plasmaschlauch 27 ein, der einen zur Wand der Plasmakammer 24 in etwa konstanten Abstand aufweist.

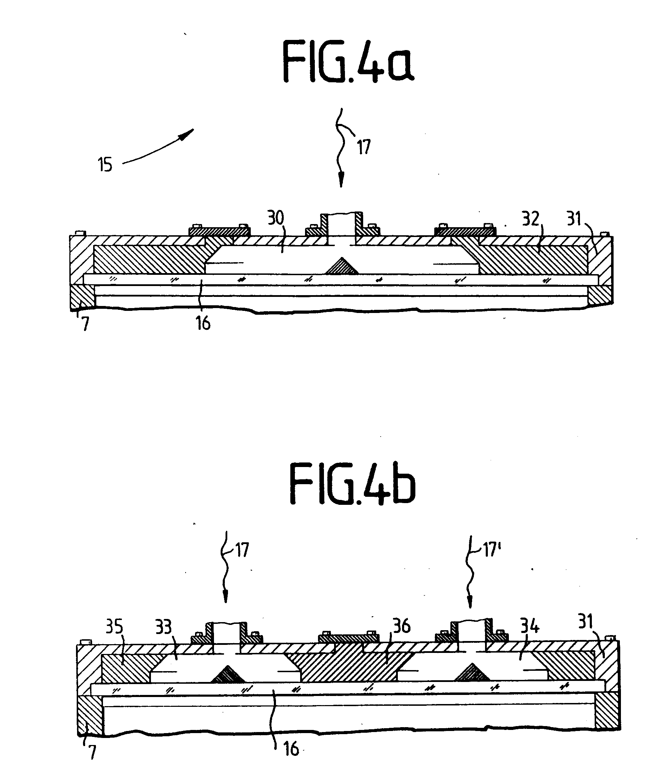

Die Einkopplung der Mikrowellen 17 (Figur 4a) aus einem »W-Hohlleiter 15 in eine Plasmakammer 7 erfolgt zum Beispiel durch ein T-förmiges Koppelglied 30. Dieses ist in einen Halterahmen 31 eingesetzt, justiert und befestigt. Der verbleibende Freiraum zwischen Koppelglied 30 einerseits, und Halterahmen 31 sowie Koppelfenster 16 andererseits wird durch ein Füllstück 32 ausgefüllt.

Durch Austausch des Koppelglieds 30 und des Füllstücks 32 (Figur 4b) gegen zwei verkleinerte T-förmige Koppelglieder 33, 34 sowie zwei Füllstücke 35, 36 läßt sich mit relativ geringem Aufwand die Verteilung der Mikrowellen 17, 17′ in der Plasmakammer 7 und somit auch die Plasmaverteilung variieren.

### Bezugszeichenliste

- 1: Kammerwand
- 2: Vakuumkammer
- 3: Öffnung
- 3a, 3b: Begrenzungsfläche
- 4: Substrat
- 5: Gitter (Plasma-confinement)
- 5a: Öffnung
- 6: Reaktivgaszuführung
- 7: Plasmakammer
- 7a, 7b: Wandfläche
- 7c, 7d: Seitenwand, Kammerwand
- 8: Magnet
- 9: Magnet
- 10: Joch
- 11: Gaszuführung
- 12: Schutzfenster
- 13: Spalt
- 14: Öffnung
- 15: Hohlleiter
- 16: Koppelfenster
- 17, 17′: Mikrowellen
- 18: Zwischenplasma
- 19: Plasma
- 20: Magnet
- 21: Magnet
- 22: Magnet
- 23: Joch
- 24: Plasmakammer
- 25: Magnetfeldlinien
- 26: Magnetfeldlinien
- 27: Plasma
- 28: Plasma
- 29: Magnetische Flasche
- 30: Koppelglied
- 31: Halterahmen
- 32: Füllstück
- 33: Koppelglied
- 34: Koppelglied
- 35: Füllstück
- 36: Füllstück

## Patentansprüche

1. Vorrichtung für Ionenätz- und plasmaunterstützte CVD-Verfahren in Durchlaufanlagen zur Behandlung großflächiger Substrate (4), mit einem ein Plasma (19) vollständig umschließenden mit einer Vakuumbeschichtungskammer (2) durch eine gemeinsame Öffnung (3) in der Kammerwand (1) korrespondierenden Behälter (7), in dem von einer Magnetanordnung (8, 9, 10) zwischen mindestens zwei um den Behälter herumlaufenden Polen ein die Elektronen-Zyklotron-Resonanz-Bedingung erfüllendes Magnetfeld erzeugt wird, einem mit dem Behälter (7) durch eine Öffnung (14) verbundenen Hohlleiter (15) für die Zuführung von elektromagnetischen Wellen, vorzugsweise Mikrowellen (17), zur Erzeugung des Plasmas (19), einem die Öffnung (14) zwischen Hohlleiter (15) und Behälter verschließenden, für Mikrowellen (17) durchlässigen Koppelfenster (16) sowie einer Gaszuführungseinrichtung zur Versorgung des Plasmaprozesses mit Reaktiv- und beispielsweise Inertgas, **dadurch gekennzeichnet,** daß
a) sich im Behälter (7) unmittelbar vor dem Koppelfenster (16) ein weiteres Schutzfenster (12) befindet, das von den umgebenden Behälterwänden (7c, 7d) thermisch gut entkoppelt ist und einen in etwa konstanten Spalt (13) zu den Behälterwänden (7c, 7d) aufweist,
b) eine getrennte Zuführung von Inert-, O₂- oder N₂-Gas (11) in den Raum zwischen Koppelfenster (16) und Schutzfenster (12) sowie von Reaktivgas (6) in den Raum zwischen Schutzfenster (12) und Substrat (4) erfolgt und
c) zwischen Koppel- (16) und Schutzfenster (12) ein Zwischenplasma (18) zündbar ist über das die Leistungsverteilung der Mikrowellen beeinflußbar ist.

2. Vorrichtung nach Anspruch 1, **dadurch gekennzeichnet,** daß der Behälter (7) beispielsweise mittels einer Flanschverbindung schnell lösbar mit der Kammerwand (1) der Vakuumkammer (2) verbindbar ist.

3. Vorrichtung nach Anspruch 1 oder 2, **dadurch gekennzeichnet,** daß eine Abschirmeinrichtung, vorzugsweise ein Gitter (5), zur Begrenzung des Plasmas (19) zwischen Behälterwand (1) und dem zu beschichtenden Substrat (4) vorgesehen ist.

4. Vorrichtung nach Anspruch 1, 2 oder 3, **dadurch gekennzeichnet,** daß die Verteilung der Mikrowellen (17) im Behälter (7) durch diverse, beispielsweise T-förmige, Koppelglieder (30, 33, 34) variabel ist.

5. Vorrichtung nach einem oder mehreren der vorhergehenden Ansprüche, **dadurch gekennzeichnet,** daß die Elektronendichte durch eine dreipolige Anordnung der Magnete (20, 21, 22) in einem Bereich innerhalb der Behälterkammer (24) erhöhbar ist.

## Claims

1. Apparatus for ion-beam etching and plasma-assisted CVD processing in continuously operating plant for the treatment of large-area substrates (4), having a vessel (7) communicating with a vacuum coating chamber (2) via a common aperture (3) in the chamber wall (1) and completely enclosing a plasma, in which vessel a magnetic device (8, 9, 10) located between at least two poles revolving around said vessel and meeting the electron-cyclotron resonance condition generates a magnetic field, also having a waveguide (15) - connected to the vessel (7) via an aperture (14) - for supplying electromagnetic waves, preferably microwaves (17) for generating the plasma (19), a coupling window (16) permeable to microwaves (17) and sealing the aperture (14) between the waveguide (15) and the vessel, and a gas supply device for supplying the plasma process with reactive and, for example, inert gas, characterised in that
a) a further protective window (12), which is thermally well insulated from the surrounding vessel walls (7c, 7d) and has an approximately constant distance (13) from the vessel walls (7c, 7d), is located in the vessel (7) directly in front of the coupling window (16)
b) a separate supply of inert, O₂, or N₂ gas (11) is fed into the space between the coupling window (16) and the protective window (12) and reactive gas (6) is fed into the space between the protective window (12) and the substrate (4), and
c) an intermediate plasma (18) via which the power distribution of the microwaves is controllable is ignitable between the coupling window (16) and the protective window (12).

2. Apparatus according to claim 1, characterised in that the vessel (7) is connectable in a rapidly detachable manner to the chamber wall (1) of the vacuum chamber (2), e.g. by means of a flange connection.

3. Apparatus according to claim 1 or 2, characterised in that a shielding device, e.g. a mesh (5), is provided in order to confine the plasma between the vessel wall (1) and the substrate (4) to be coated.

4. Apparatus according to claim 1, 2 or 3, characterised in that the distribution of microwaves (17) in the vessel (7) is variable by diverse, e.g. T-shaped, coupling members (30, 33, 34).

5. Apparatus according to one or more of the preceding claims, characterized in that the electron density can be increased by a three-pole arrangement of the magnets (20, 21, 22) in a region inside the vessel chamber (24)

## Revendications

1. Dispositif pour des procédés d'attaque ionique et CVD assisté par plasma dans des installations continues pour le traitement de substrats de grande surface (4), comportant un récipient (7) entourant totalement un plasma (19) et communiquant avec une chambre de revêtement sous vide (2) par une ouverture commune (3) dans la paroi de chambre (1), dans lequel un champ magnétique remplissant la condition de résonance électron-cyclotron est produit par un agencement d'aimants (8, 9, 10) entre au moins deux pôles qui s'étendent autour du récipient, un guide d'ondes (15) relié au récipient (7) par une ouverture (14) pour l'introduction d'ondes électromagnétiques, de préférence de micro-ondes (17), pour produire le plasma (19), une fenêtre de couplage (16) perméable aux micro-ondes (17) qui ferme l'ouverture (14) entre le guide d'ondes (15) et le récipient ainsi qu'un dispositif d'introduction de gaz pour alimenter le procédé à plasma avec un gaz réactif et par exemple un gaz inerte, caractérisé en ce que
a) une autre fenêtre de protection (12) qui y est bien découplée thermiquement des parois de récipient (7c, 7d) qui l'entourent et qui présente une fente sensiblement constante (13) par rapport aux parois de récipient (7c, 7d) se trouve dans le récipient (7) immédiatement devant la fenêtre de couplage (16),
b) il se produit une introduction séparée de gaz inerte, de O₂ ou de N₂ (11) dans l'espace entre la fenêtre de couplage (16) et la fenêtre de protection (12) et de gaz réactif (6) dans l'espace entre la fenêtre de protection (12) et le substrat (4) et
c) un plasma intermédiaire (18) par l'intermédiaire duquel la répartition de puissance des micro-ondes peut être influencée peut être allumé entre la fenêtre de couplage (16) et la fenêtre de protection (12).

2. Dispositif selon la revendication 1, caractérisé en ce que le récipient (7) peut être relié de manière rapidement amovible à la paroi de chambre (1) de la chambre à vide (2), par exemple au moyen d'une liaison à brides.

3. Dispositif selon la revendication 1 ou 2, caractérisé en ce qu'il est prévu un dispositif d'écran, de préférence une grille (5), pour limiter le plasma (19) entre la paroi de récipient (1) et le substrat à revêtir (4).

4. Dispositif selon la revendication 1, 2 ou 3, caractérisé en ce que la répartition des micro-ondes (17) dans le récipient (7) est rendue variable par divers éléments de couplage (30, 33, 34) par exemple en forme de T.

5. Dispositif selon une ou plusieurs des revendications précédentes, caractérisé en ce que la densité électronique peut être augmentée par un agencement tripolaire des aimants (20, 21, 22) dans un domaine à l'intérieur de la chambre de récipient (24).
